# EUROPEAN PATENT APPLICATION

(11) **EP 2 284 004 A1**
(43) Date of publication of application: **16.02.2011**
(21) Application number: 09167787.2
(22) Date of filing: 13.08.2009
(51) Int. Cl.: B32B 27/04, C08G 59/62, C08G 59/68, H05K 1/03

(54) **Electric circuit board composition and a method of preparing circuit board**

(71) Applicant: NAN YA PLASTICS CORP., Taipei (TW)
(72) Inventor: Tzou, Ming-Jen, Taipei (TW); Chiang, Jung-Chung, Taipei (TW); Wei, Wen-Lung, Taipei (TW); Lu, Jung-Che, Taipei (TW)
(74) Representative: Viering, Jentschura & Partner

(57) **Abstract**

The present invention provides a new epoxy resin which is modified with halide and oxazolidone ring. This epoxy resin can improve the peeling strength, Tg, heat resistance, and flame resistance for CCL and be used for print circuit board. The composition comprising (A) a halogen-containing epoxy which containing a oxazolidone ring, about 5∼95wt% of total weight, (B) epoxy resins with two or above epoxy groups, about 95∼5 wt% of total weight, (C) a curing agent, example of phenol novolac, and (D) a curing accelerator. After laminating the prepreg which had been made by impregnation of the mentioned composition at 170∼210°C with 10∼30kgf/cm², the electric circuit board composition with excellent properties can be obtained. This epoxy resin composition in this invention can achieve the peeling strength>10Ibf/inch, glass transition temperature>155°C, water absorption<0.2, outstanding heat resistance and pass the UL94 V-0 flame resistance test. That can be applied to high performance electronic materials widely.

## Description

### BACKGROUND OF THE INVENTION

### 1. FIELD OF THE INVENTION

The present invention relates to a synthesis of an epoxy resin modified with halide and oxazolidone ring. This epoxy resin can improve the peeling strength between board and copper foil, Tg, heat resistance, and flame resistance for CCL and be used for print circuit board. The board has characteristic of well reactivity, wide working window, improvement of toughness etc. And that has an excellent process and operation. Further the board material which had been laminated achieves the excellent peeling strength, outstanding heat resistance, lower water absorption and passes the UL94 V-0 flame resistance test.

### 2. DESCRIPTION OF THE RELATED ART

Methods of preparing epoxy resin modified with oxazolidone ring in the past include:
U. S. Pat. No. 3,334,110 is dissolved isocyanate resin, epoxy resin and catalyst tetramethylammonium bromide in methanol and reacted in 105°C until isocyanate is reacted completely. The feature of the present invention uses tetramethylammonium bromide salt as catalyst, and its reaction temperature is 60 ∼150°C.
U. S. Pat. No. 4,066,628 is mixed isocyanate resin and epoxy resin in cellosolve acetate, and added catalyst (ZnR₂, Zn(OCOR)₂, ZnX, AIR₃, etc.) in 150°C . And the reaction is made under 150°C for 7 hours. This patent mainly emphasizes that polyoxazolidone-imide resin can be prepared from different type of catalysts, so as to obtain polyoxazolidone-imide film with an outstanding impact intensity, anti-solvent, and heat stability.
U. S. Pat. No. 4,070,416 is related to epoxy resin modified with oxazolidone ring can be synthesized by catalysts such as tertiary amine, alkoxy amine, morpholine, quaternary ammonium salt, imidazole etc. thereinto, the weight ratio of isocyanate to epoxy resin is 2∼3.5 : 1. Thermosetting resin is hardened at 80∼250°C without solvent. It is able to be used in molding, sealing, adhesive agent and print circuit board.
U. S. Pat. No. 5,112,932 is related to that polyoxazolidone resin with epoxy groups at terminal end can be obtained from the epoxy resin added 0.03% catalyst of 2-phenol imidazol (2-PZ) and toluene-2,6-diisocyanate (TDI) titrated over 30 minutes in 160°C. The reaction maintains in 160°C for 1 hour. Tg (glass transition temperature ) is above 135°C after the resin hardening. The features of this patent are to utilize reaction temperature, catalyst quantity, or dropping rate of isocyanate to control the formation of oxazolidone or fulminuric acid ester ring. Thereinto, catalyst is imidazole or tetraphenyl phosphonium bromide. The composition of the thermosetting resin is including the polyoxazolidone resin with epoxy groups at terminal end, epoxy resin, hardening agent, solvent and accelerator. This composition can be applied to materials of PCB.
U. S. Pat. No. 5,545,697 is related to epoxy resin modified with oxazolidone ring can be obtained from adding 0.1% catalyst tetramethylammonium iodide into epoxy resin, TDI drops over in 120 minutes at 175°C. And then keep the temperature 175°C for three hours. Elements of this patent include: (A) halogen-free epoxy resin containing oxazolidone ring structure; (B) halogen-containing epoxy resin and (C) hardener, the weight ration of (A) to (B) is 5∼95 : 95∼5.

This patent shows that non-halogen resin contains oxazolidone structure, used with halogen containing epoxy resin and hardener at the same time. It can be used for paint, bonds (adhesive), packaging materials, composite materials and composite laminate materials. The catalyst in the reaction can be lithium compound, quarternary ammonium salt, tertiary amine, phosphorus compounds and imidazole. The reaction temperature is 140 ∼ 200°C.

### TECHNICAL OBJECTS TO BE RESOLVED

In order to achieve flame-resistant, tetrabromobisphenol A (TBBA) or brominated epoxy resin is often added in the varnish. But if tetrabromobisphenol A is added directly, the heat-resistant of board material is poor because of the incompletely reaction; if brominated epoxy resin is used, the heat-resistance and bond are poor because its structure is harder than the general non-bromine epoxy resin's. Through in previous technical method in the U. S. Patent No. 5,112,932, using toluene diisocyanate and epoxy resin to modify the resin. Although the resin can improve the bonding, but TBBA and brominated epoxy are still needed to add in order to improve the flame-resistance. In order to improve the above-mentioned shortcomings, the present invention is firstly to react toluene diisocyanate and bromide epoxy resin directly and then to add them into epoxy varnish, so that it can enable wider working window, and can improve the heat-resistant of board material without tetrabromobisphenol A and brominated epoxy resin.

So far as the printed circuit laminated plate is concerned, international norms call for lead-free process with environmental protection. Thus, the requirement on the processing of the substrate is particularly stringent, especially the operations such as heat-resistance of the substrate in the tin furnace have already become important subjects in the industry to have overcome. In the past, substrates used in copper foil are glass fiber cloth treated with epoxy resin varnish, so that the circuit plate is containing particle fillers, hardeners, brominated flame retardant agents. Thereinto, the most commonly used hardener is dicyandiamide it can be hardened in the course of high-temperature and hot pressing. However, the heat-resistant of substrate is often poor for dicyandiamide being easily sopping up. To overcome this shortcoming, the present invention is to use phenolic resin as hardening agents. Due to the hardening agents of phenolic resin having benzene ring structure, the heat-resistance of the substrate can be improved accordingly.

### SUMMARY OF THE INVENTION

The first purpose of the present invention is to provide circuit boards components with excellent high temperature properties. After the test of it is done in the pressure cookers for 0.5 hours and placed in the tin furnace at 288°C, the stability is more than 600 seconds.

The second purpose of the present invention is to provide a kind of circuit board components, and the peeling strength of it can also be more than 10 Ibf/inch when 1 oz of common copper foil is used.

The third purpose of the present invention is to provide a kind of circuit board components, in which the moisture absorption rate is generally lower than the existing used copper foil substrate.

The fourth purpose of the present invention is to provide a kind of circuit board components containing flame retardant composition which can be passed the UL94 V-0 even the bromine containing is in a lower level.

The present invention is to provide a kind of halide-containing epoxy resin composition modified with oxazolidone ring structure applied for print circuit board, comprising:
(A) epoxy resin with 5∼95wt% oxazolidone ring which is obtained from that halide-containing epoxy resin mixed with the catalyst quaternary ammonium salt and then directly to react with isocyanate, (B) having about 95 ∼ 5wt% of the epoxy resin with two or more epoxy groups, which can be brominated epoxy resin or halogen-free epoxy resin, such as multi-functional phenolic epoxy resin. (C) hardener, mainly phenolic resin, the ratio of hardener/epoxy resin is 0.5/1∼1.5/1, and a small quantity of (D) accelerator, mainly imidazole catalyst, the amount of which is 0.01 ∼ 0.5phr based on total weight of epoxy resin.

### THE TECHNICAL MEANS OF THE INVENTION:

The extremely main technical feature of the present invention is to add a brominated epoxy resin with the structure of oxazolidone ring. The brominated epoxy resin is able to improve flame resistance, and then brominating epoxy resin with oxazolidone ring structure can improve the peeling strength between substrate and copper foil, Tg, heat resistance, and flame resistance. Owing to the costs of the raw materials isocyanate resin is low, the manufacturing process is easy so as to have a value on the industry.

The other technical feature of the present invention is to use phenolic resin as a hardener, that can improve heat resistance of the base board, decrease the moisture absorption rate, in accordance with lead-free process requirements.

A manufacturing method for the preparation of a circuit board of the present invention includes the following steps:
(a) at first, directly to mix about 5 ∼ 95wt% of the total brominated epoxy resin and tetraethyl ammonium bromine catalysts with isocyanate to make reaction to form modified brominated epoxy resin containing oxazolidone;
(b) then about 95 ∼ 5wt% of the total amount epoxy resin containing two or more epoxy groups and the halogen-free epoxy resin mixed uniform;
(c) doped with hardener and accelerator;
(d) to use the glass fiber cloth treated to produce prepreg at 160∼180°C; and
(e) to be pressed the prepreg at 170∼210°C under 10 ∼ 30kgf/cm² so as to form circuit boards.

### EMBODIMENT

The resin substrate, hardener, accelerator, glass fiber cloth and their source used in the present invention are given in details as follows.

### 1. Resin substrate

Resin substrate used in circuit board materials of the present invention is a thermosetting resin composition, including (1) halide-containing epoxy resin with oxazolidone ring, (2) halide-containing epoxy resin, and (3) halogen-free epoxy resin, taking part in the cross-linking reaction during the hardening period.

Thereinto, halide-containing epoxy resin with oxazolidone ring (1) is synthesized at a high temperature by brominated epoxy resin and isocyanate (such as toluene diisocyanate). The catalyst is quaternary ammonium such as tetraethyl ammonium bromide, epoxide equivalent weight (EEW) of the product is 200 ∼ 2000g/eq, and molecular weight (MW) = 500 ∼ 5000 g/mol, please refer to Examples 1 to 3.

Another halide-containing epoxy resin (2) is formed by the modification of phenolic epoxy resin and terabromobisphenol-A, and triphenyl phosphate (TPP) is used as the catalyst, the epoxide equivalent weight (EEW) of the product is 100 ∼ 1000g/eq, molecular weight (MW) = 1000 ∼ 5000g/ mol, please refer to synthetic example of Example 4.

The halogen-free epoxy resin is containing phenolic epoxy resin or multi-functional phenolic epoxy resin, such as NAN YA PLASTICS CORPORATION's products of NPPN-431, NPPN-638, NPCN-704, etc., and phenolic epoxy resin of Bisphenol-A type, such as NAN YA PLASTICS CORPORATION's products of NPPN-438.

### 2. Hardener

In order to improve the heat-resistant of the substrate, and glass transition temperature during the processing of lead-free soldering tin, hardener in the present invention is to use phenolic epoxy resin. The equivalent ratio of the hardener/epoxy resin is 0.5/1 to 1.5/1. In addition to phenolic resin such as NAN YA PLASTICS CORPORATION NPEH-710H and the resin of Bisphenol-A type such as NAN YA PLASTICS CORPORATION NPEH-720H, the hardener still includes the resin of glyoxal type (TPN, in NAN YA PLASTICS CORPORATION), benzaldehyde type resin (BPN, in NAN YA PLASTICS CORPORATION), salicylaldehyde type resin (SPN, in NAN YA PLASTICS CORPORATION), the m-hydroquinone type resin (RFN, in NAN YA PLASTICS CORPORATION) and melamine-phenolic type resin (LA-1356, melamine type novolac, DAINIPPON INK AND CHEMICALS INCORPORATED (DIC)). The structure formula of all hardeners are as the following in Table 1.

**Table 1 : structure formula of all hardeners**

| | |
|---|---|
| phenolic type resin | glyoxal type resin |
| 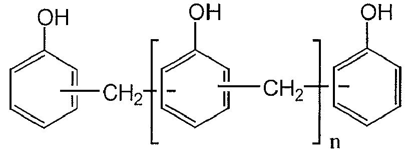 | 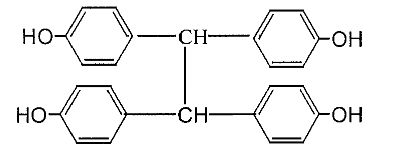 |
| benzaldehyde type resin | salicylaldehyde type resin |
| 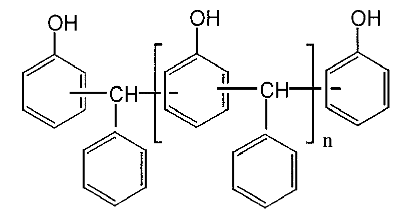 | 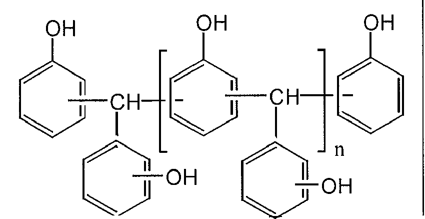 |
| inter-hydroquinone type resin | bisphenol type resin |
| 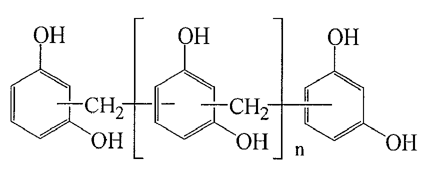 | 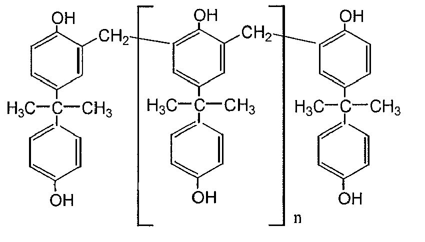 |
| melamine-phenolic type resin | |
| 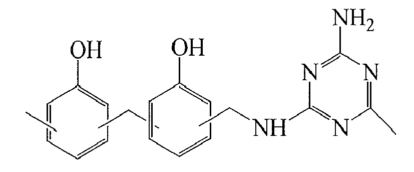 | |

### 3. Accelerator

The imidazole catalyst is used as accelerator, such as 2-Methylimidazole (2-MZ), 2-phenyl imidazole (2-PZ), 2-ethyl-4-Methylimidazole (2E4MZ), and so on. The amount of epoxy resin is for 0.01 ∼ 0.5phr.

### 4. Glass fiber cloth

Glass fiber cloth used in the present invention is about 10∼20wt% of the total composition, glass fiber cloth produced in the NAN YA PLASTICS CORPORATION is used as reinforcement materials. According to the requirement of substrate, glass fiber cloth of different thickness is used, and their specifications are as follows in Table 2:

**Table 2 : Type of glass fiber cloth**

| Type of cloth | Weight of (g/m²) | thickness (mm) | fiber(inch) | |
|---|---|---|---|---|
| | | | warp | woof |
| 7628 | 208 | 0.18 | 44 | 33 |
| 2116 | 105 | 0.19 | 60 | 58 |
| 1080 | 48 | 0.055 | 60 | 48 |
| 106 | 24 | 0.04 | 56 | 56 |

### EXAMPLES OF MODIFIED SYNTHESIS

### Example 1 of modified synthesis

1600g brominated epoxy resin NPEB-400 (EEW 380 ∼ 420g/eq, bromine content 46 ∼ 50%) produced by NAN YA PLASTICS CORPORATION is placed in three neck reaction bottle, heated to 140°C to remove water by introducing the nitrogen, feed 87g TDI (toluene diisocyanate, equivalent is 87) once after one hour's dehydration, then added 0.5 g tetraethyl ammonium bromide/methanol (25%) catalyst and mixed in uniform, reacted two to three hours under the temperature 150 ∼ 160°C. By taking sampling and analysis epoxy equivalent, and using FT-IR tracing oxazolidone functional groups (1755 cm⁻¹) absorption until isocyanate functional groups (2250cm⁻¹) disappear so far. Epoxy resin, which is brominated epoxy resin with oxazolidone ring, is synthesized referred to Epoxy Resin A. Its bromine content is 44.5%, and epoxy equivalent is 550g/eq, MW = 1310 g/mol. The structure formula is shown as follows.

### STRUCTURE FORMULA

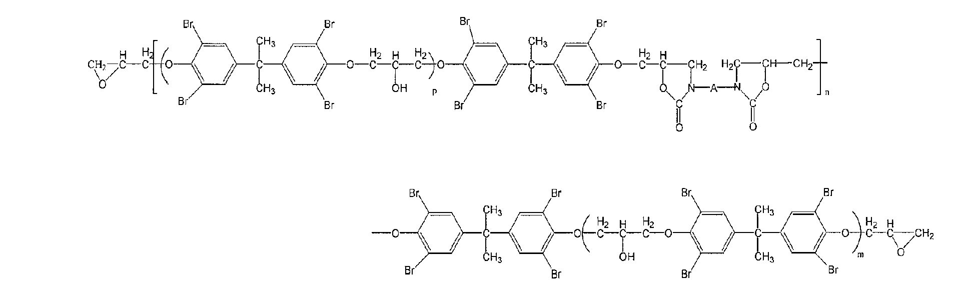

wherein A represent:
or

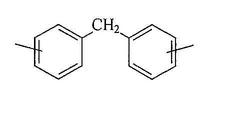

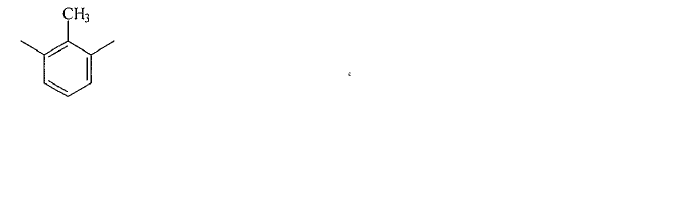

### Example 2 of modified synthesis

1200g brominated epoxy resin NPEB-400 (EEW 380 ∼ 420g/eq, bromine content 46 ∼ 50%) produced by NAN YA PLASTICS CORPORATION is placed in three neck reaction bottle, heated to 140°C to remove water by introducing the nitrogen, feed 87g TDI (toluene diisocyanate, equivalent 87) once after one hour's dehydration, and then added 0.5g tetraethyl ammonium bromide/methanol (25%) catalyst and mixed in uniform, reacted two to three hours under the temperature 150∼160°C. Epoxy resin, which is brominated epoxy resin with oxazolidone ring, is synthesized referred to Epoxy Resin B, with 43.8% bromine content, and epoxy equivalent = 635g/eq, MW = 1340g/mol.

### Example 3 of modified synthesis

1600g brominated epoxy resin NPEB-400 (EEW 380 ∼ 420g/eq, bromine content 46 ∼ 50%) produced by NAN YA PLASTICS CORPORATION is placed in three neck reaction bottle, heated to 140°C to remove water by introducing the nitrogen, feed 147g TDI (toluene diisocyanate, equivalent 87) once after one hour's dehydration, and then added 0.5g tetraethyl ammonium bromide/methanol (25%) catalyst and mixed in uniform, reacted two to three hours under the temperature 150∼160°C. Epoxy resin, which is brominated epoxy resin with oxazolidone ring, is synthesized referred to Epoxy Resin C, with 42.4% bromine content, and epoxy equivalent is 860g/eq, MW = 1360g/mol.

### Example 4 of modified synthesis

310 grams NPPN-638 (phenolic type epoxy resin, EEW = 170-190 g/eq, produced by NAN YA PLASTICS CORPORATION), 70 grams NPPN-431 (four functional epoxy resin, EEW= 200-240g/eq, produced by NAN YA PLASTICS CORPORATION), 940 grams NPEL-128E (BPA type epoxy resin, EEW=184-190g/eq, produced by NAN YA PLASTICS CORPORATION), 240 grams NPEB-400 and 440 grams tetrabromobisphenol-A are placed in the three neck bottle, then after stirring and dissolved at 120°C, adding 0.29 grams of triphenyl phosphate (TPP), and mixed in uniform, heated to 160∼170°C, and keep the temperature for 1∼2 hours. It's obtained the brominated epoxy resin referred to Epoxy Resin D, with 18.5% bromine content, epoxy equivalent is 320g/eq, MW = 2740 g/mol.

### Comparative Example 1 modified synthesis

1,000 grams bisphenol-A type epoxy resin (EEW 185 g/eq) are placed in three neck reaction bottle, added 5 grams catalyst of tetramethylammonium iodide and mixed. Dropping 170 grams toluene diisocyanate (TDI) into reaction bottle at 175°C in 120 minutes, before reacting 3 hours at 175°C. And then adding 900 grams epoxy resin modified with bromide (from the synthesis of tetrabromobisphenol, epoxy equivalent to 407g/eq, bromine content 48.3%), stirring and mixing at 120°C in 1 hour. Epoxy resin, which is bromianted epoxy resin with oxazolidone ring, is synthesized and obtained as referred to Epoxy Resin E, with 18% bromine content and epoxy equivalent is 360g/eq.

### EXAMPLE

Related to trial-produced circuit boards mentioned in example of the present invention, raw materials used contain not only resin and epoxy resin modified with bromide, but also the other materials such as Table 3:

**Table 3: specification and resource of materiel of circuit broads**

| manufacturer | | Commercial name | Material specification |
|---|---|---|---|
| NAN PLASTICS CORPORATION | YA | NPPN-431 | EEW=210g/eq, multi-functional phenolic epoxy resin |
| NAN PLASTICS CORPORATION | YA | NPPN-638 | EEW=180g/eq, phenolic epoxy resin |
| NAN PLASTICS CORPORATION | YA | NPEH-710 H | OH EW=100g/eq, phenolic resin |
| NAN PLASTICS | YA | NPEH-720 H | OH EW= 120 g/eq, isphenol resin |
| CORPORATION | | | |
| NAN | YA | | |
| PLASTICS | | TPN | OH EW= 100 g/eq, glyoxal resin |
| CORPORATION | | | |
| NAN | YA | | |
| PLASTICS | | BPN | OH EW= 180 g/eq, benzaldehyde resin |
| CORPORATION | | | |
| NAN | YA | | |
| PLASTICS | | SPN | OH EW= 90 g/eq, salicylaldehyde resin |
| CORPORATION | | | |
| NAN | YA | | |
| PLASTICS | | RFN | OH EW= 55 g/eq, m-hydroquinone resin |
| CORPORATION | | | |
| DAINIPPON | INK | | |
| AND CHEMICALS | | LA-1356 | OH EW= 146 g/eq, melamine-phenolic resin |
| INCORPORATED | | | |

### Example 1

350 in the weight of epoxy resin A, 200 in the weight of epoxy resin D, 35 in the weight of NPPN-431 resin and 125 in the weight of NPPN-638 resin are evenly mixed and then doped with 267.4 in the weight of hardener of NPEH-720H; and 0.4 in the weight of accelerator (2 - MZ) evenly mixed. It's treated with glass fiber cloth (7628) produced by in NAN YA PLASTICS CORPORATION. And semi-hardened into the film in 160 ∼ 180°C . It's stacked with five to eight film, from top to bottom by wrapped with copper foil I oz produced by NAN YA PLASTICS CORPORATION. Circuit boards materials are by pressing materials in the 10∼30kgf/cm² under 160∼210 °C for two hours, the physical measurement data such as listed in Table 4.

### Example 2

270 in the weight of epoxy resin A, 280 in the weight of epoxy resin D, 35 in the weight of NPPN-431 resin and 125 in the weight of NPPN-638 resin are evenly mixed and then doped with 280.6 in the weight of hardener of NPEH-720H; and 0.4 in the weight of accelerator (2 - MZ) evenly mixed. It's treated with glass fiber cloth (7628) produced by in NAN YA PLASTICS CORPORATION. And semi-hardened into the film in 160 ∼ 180 °C. It's stacked with five to eight film, from top to bottom by wrapped with copper foil I oz produced by NAN YA PLASTICS CORPORATION. Circuit boards materials are made by pressing materials in the 10∼30kgf/cm² under 160∼210°C for two hours, the physical measurement data such as listed in Table 4.

### Example 3

350 in the weight of epoxy resin B, 200 in the weight of epoxy resin D, 35 in the weight of NPPN-431 resin and 125 in the weight of NPPN-638 resin are evenly mixed and then doped with 280.6 in the weight of hardener of NPEH-720H; and 0.4 in the weight of accelerator (2 - MZ) evenly mixed. It's treated with glass fiber cloth (7628) produced by in NAN YA PLASTICS CORPORATION. And semi-hardened into the film in 160 ∼ 180 °C. It's stacked with five to eight film, from top to bottom by wrapped with copper foil I oz produced by NAN YA PLASTICS CORPORATION. Circuit boards materials are made by pressing materials in the 10∼30kgf/cm² under 160∼210°C for two hours, the physical measurement data such as listed in Table 4.

### Example 4

270 in the weight of epoxy resin B, 280 in the weight of epoxy resin D, 35 in the weight of NPPN-431 resin and 125 in the weight of NPPN-638 resin are evenly mixed and then doped with 280.6 in the weight of hardener of NPEH-720H; and 0.4 in the weight of accelerator (2 - MZ) evenly mixed. It's treated with glass fiber cloth (7628) produced by in NAN YA PLASTICS CORPORATION. And semi-hardened into the film in 160 ∼ 180 °C. It's stacked with five to eight film, from top to bottom by wrapped with copper foil I oz produced by NAN YA PLASTICS CORPORATION. Circuit boards materials are made by pressing materials in the 10∼30kgf/cm² under 160∼210°C for two hours, the physical measurement data such as listed in Table 4.

### Example 5

350 in the weight of epoxy resin C, 200 in the weight of epoxy resin D, 35 in the weight of NPPN-431 resin and 125 in the weight of NPPN-638 resin are evenly mixed and then doped with 238.5 in the weight of hardener of NPEH-720H; and 0.4 in the weight of accelerator (2 - MZ) evenly mixed. It's treated with glass fiber cloth (7628) produced by in NAN YA PLASTICS CORPORATION. And semi-hardened into the film in 160 ∼ 180 °C. It's stacked with five to eight film, from top to bottom by wrapped with copper foil I oz produced by NAN YA PLASTICS CORPORATION. Circuit boards materials are made by pressing materials in the 10∼30kgf/cm² under 160∼210°C for two hours, the physical measurement data such as listed in Table 4.

### Example 6

270 in the weight of epoxy resin C, 280 in the weight of epoxy resin D, 35 in the weight of NPPN-431 resin and 125 in the weight of NPPN-638 resin are evenly mixed and then doped with 258.3 in the weight of hardener of NPEH-720H; and 0.4 in the weight of accelerator (2 - MZ) evenly mixed. It's treated with glass fiber cloth (7628) produced by in NAN YA PLASTICS CORPORATION. And semi-hardened into the film in 160 ∼ 180 °C. It's stacked with five to eight film, from top to bottom by wrapped with copper foil I oz produced by NAN YA PLASTICS CORPORATION. Circuit boards materials are made by pressing materials in the 10∼30kgf/cm2 under 160∼210°C for two hours, the physical measurement data such as listed in Table 4.

### Comparative Example 1

350 in the weight of epoxy resin E, 200 in the weight of epoxy resin D, 35 in the weight of NPPN-431 resin and 125 in the weight of NPPN-638 resin are evenly mixed and then doped with 280 in the weight of hardener of NPEH-720H; and 0.4 in the weight of accelerator (2 - MZ) evenly mixed. It's treated with glass fiber cloth (7628) produced by in NAN YA PLASTICS CORPORATION. And semi-hardened into the film in 160 ∼ 180 °C . It's stacked with five to eight film, from top to bottom by wrapped with copper foil I oz produced by NAN YA PLASTICS CORPORATION. Circuit boards materials are made by pressing materials in the 10∼30kgf/cm² under 160∼210°C for two hours, the physical measurement data such as listed in Table 4.

### Comparative example 2

350 in the weight of brominated epoxy resin NPEB-400, 200 in the weight of epoxy resin D, 35 in the weight of NPPN-431 resin and 125 in the weight of NPPN-638 resin are evenly mixed and then doped with 283.3 in the weight of hardener of NPEH-720H; and 0.4 in the weight of accelerator (2 - MZ) evenly mixed. It's treated with glass fiber cloth (7628) produced by in NAN YA PLASTICS CORPORATION. And semi-hardened into the film in 160 ∼ 180 °C. It's stacked with five to eight film, from top to bottom by wrapped with copper foil I oz produced by NAN YA PLASTICS CORPORATION. Circuit boards materials are made by pressing materials in the 10∼30kgf/cm² under 160∼210°C for two hours, the physical measurement data such as listed in Table 4. Comparative example 3

270 in the weight of brominated epoxy resin NPEB-400, 280 in the weight of epoxy resin D, 35 in the weight of NPPN-431 resin and 125 in the weight of NPPN-638 resin are evenly mixed and then doped with 289.3 in the weight of hardener of NPEH-720H; and 0.4 in the weight of accelerator (2 - MZ) evenly mixed. It's treated with glass fiber cloth (7628) produced by in NAN YA PLASTICS CORPORATION. And semi-hardened into the film in 160 ∼ 180 °C. It's stacked with five to eight film, from top to bottom by wrapped with copper foil I oz produced by NAN YA PLASTICS CORPORATION. Circuit boards materials are made by pressing materials in the 10∼30kgf/cm² under 160∼210°C for two hours, the physical measurement data such as listed in Table 4.

**Table 4**

| constitute | example | | | | | | Comparative example | | |
|---|---|---|---|---|---|---|---|---|---|
| materiel/weight | 1 | 2 | 3 | 4 | 5 | 6 | 1 | 2 | 3 |
| Resin A | 350 | 270 | | | | | | | |
| Resin B | | | 350 | 270 | | | | | |
| Resin C | | | | | 350 | 270 | | | |
| Resin D | 200 | 280 | 200 | 280 | 200 | 280 | | 200 | 280 |
| Resin E | | | | | | | 350 | | |
| NPEB-400 | | | | | | | 200 | 350 | 270 |
| NPPN-431 | 35 | 35 | 35 | 35 | 35 | 35 | 35 | 35 | 35 |
| NPPN-638 | 125 | 125 | 125 | 125 | 125 | 125 | 125 | 125 | 125 |
| NPEH-720H | 267.4 | 280.6 | 256.7 | 272.3 | 238.5 | 258.3 | 280.0 | 28 3.3 | 289.3 |
| 2-MZ | 0.4 | 0.4 | 0.4 | 0.4 | 0.4 | 0.4 | 0.4 | 0.4 | 0.4 |
| Bromide content (%) | 19.7 | 17.3 | 19.7 | 17.3 | 19.5 | 17.2 | 16.1 | 20.6 | 18.1 |

| measurement data | | | | | | | | | |
|---|---|---|---|---|---|---|---|---|---|
| project/data | 1 | 2 | 3 | 4 | 5 | 6 | 1 | 2 | 3 |
| Peeling strength (Ibf/inch) | 11.9 | 11.5 | 12.5 | 11.8 | 13.2 | | 12.6 11.6 | 7.8 | 7.6 |
| Tg(°C) from DSC measurement | 157.4 | 156.3 | 157.9 | 157.1 | 158.4 | 157.5 | 153.6 | 149. 6 | 150.8 |
| Pressure cooker 0.5hr | | | | | | | | | |
| Wet absorption (wt%) | 0.18 | 0.17 | 0.19 | 0.18 | 0.19 | 0.19 | 0.20 | 0.23 | 0.22 |
| Heat resistance soldering tin (sec) | of >600 | >600 | >600 | >600 | >600 | >600 | 520 | 480 | 510 |
| From TMA test to T-288 layer test (min) | 28.6 | 32.1 | 26.8 | 30.5 | 24.7 | 28.8 | 23.2 | 21.4 | 22.2 |
| 5% heat cracking | | | | | | | | | |
| temp (°C) from TGA measurement | 355 | 360 | 356 | 359 | 357 | 358 | 355 | 353 | 352 |
| Retardant UL-94 | V-0 | V-0 | V-0 | V-0 | V-0 | V-0 | V-0 | V-0 | V-0 |

| | | | | | | | | | |
|---|---|---|---|---|---|---|---|---|---|
| * physical measurement with reference to IPC-TM-650 norms. * DSC: Differential Scanning Calorimeter * TMA: Thermomechanical analyzer * TGA Thermogravimetry Analyzer | | | | | | | | | |

Physical measurement analysis:

For brominated epoxy resin with oxazolidone ring (resin A ∼ C, resin E), peeling strength of resin C and copper foil is the best one. It is known that the higher oxazolidone ring contained, the better copper foil peeling strength as possible. The peeling strength is 11 Ibf/inch and above. It's far better than those one of the bromide resin substrate without oxazolidone structure.

Brominated Epoxy resin with oxazolidone ring (resin A ∼ C) acted as main resin may improve the Tg of the substrate. In comparison with high brominated epoxy resin with oxazolidone structure (resin E) mixed-doped with no halogen resin, its substrate Tg is approximately 3°C higher than resin modified with oxazolidone ring, and approximately 6°C higher than resin modified with no oxazolidone ring and bromide.

Increasing the amount of resin D resin used in the substrate can improve heat resistance, it's effect is better than NPEB-400's.

Examples 7 to 13 are to use different types of phenolic resin as hardener, while comparative examples 4 and 5 are used dicyandiamide as hardener to compare the differences of the cases.

### Example 7

270 in the weight of epoxy resin A, 280 in the weight of epoxy resin D, 90 in the weight of NPPN-431 resin and 70 in the weight of NPPN-638 resin are evenly mixed and then doped with 229.3 in the weight of hardener of NPEH-720H; and 0.4 in the weight of accelerator (2 - MZ) evenly mixed. It's treated with glass fiber cloth (7628) produced by in NAN YA PLASTICS CORPORATION. And semi-hardened into the film in 160 ∼ 180 °C. It's stacked with five to eight film, from top to bottom by wrapped with copper foil I oz produced by NAN YA PLASTICS CORPORATION. Circuit boards materials are made by pressing materials in the 10∼30kgf/cm² under 160∼210°C for two hours, the physical measurement data such as listed in Table 5.

### Example 8

270 in the weight of epoxy resin A, 280 in the weight of epoxy resin D, 90 in the weight of NPPN-431 resin and 70 in the weight of NPPN-638 resin are evenly mixed and then doped with 275.1 in the weight of NPEH-720H resin; and 0.4 in the weight of accelerator (2 - MZ) evenly mixed. It's treated with glass fiber cloth (7628) produced by in NAN YA PLASTICS CORPORATION. And semi-hardened into the film in 160 ∼ 180 °C. It's stacked with five to eight film, from top to bottom by wrapped with copper foil I oz produced by NAN YA PLASTICS CORPORATION. Circuit boards materials are made by pressing materials in the 10∼30kgf/cm² under 160∼210 °C for two hours, the physical measurement data such as listed in Table 5.

### Example 9

270 in the weight of epoxy resin A, 280 in the weight epoxy resin D, 90 in the weight of NPPN-431 resin and 70 in the weight of NPPN-638 resin are evenly mixed and then doped with 412.7 in the weight of hardener of the benzaldehyde resin (BPN); and 0.4 in the weight of accelerator (2 - MZ) evenly mixed. It's treated with glass fiber cloth (7628) produced by in NAN YA PLASTICS CORPORATION. And semi-hardened into the film in 160 ∼ 180 °C. It's stacked with five to eight film, from top to bottom by wrapped with copper foil I oz produced by NAN YA PLASTICS CORPORATION. Circuit boards materials are made by pressing materials in the 10∼30kgf/cm² under 160∼210°C for two hours, the physical measurement data such as listed in Table 5.

### Example 10

270 in the weight of epoxy resin A, 280 in the weight of epoxy resin D, 90 in the weight of NPPN-431 resin and 70 in the weight of NPPN-638 resin are evenly mixed and then doped with 206.3 in the weight of hardener of the salicylaldehyde resin (SPN); and 0.4 in the weight of accelerator (2 - MZ) evenly mixed. It's treated with glass fiber cloth (7628) produced by in NAN YA PLASTICS CORPORATION. And semi-hardened into the film in 160 ∼ 180 °C. It's stacked with five to eight film, from top to bottom by wrapped with copper foil I oz produced by NAN YA PLASTICS CORPORATION. Circuit boards materials are made by pressing materials in the 10∼30kgf/cm² under 160∼210°C for two hours, the physical measurement data such as listed in Table 5.

### Example 11

270 in the weight of epoxy resin A, 280 in the weight of epoxy resin D, 90 in the weight of NPPN-431 resin and 70 in the weight of NPPN-638 resin are evenly mixed and then doped with 229.3 in the weight of hardener of the glyoxal resins (TPN); and 0.4 in the weight of accelerator (2 - MZ) evenly mixed. It's treated with glass fiber cloth (7628) produced by in NAN YA PLASTICS CORPORATION. And semi-hardened into the film in 160 ∼ 180°C. It's stacked with five to eight film, from top to bottom by wrapped with copper foil I oz produced by NAN YA PLASTICS CORPORATION. Circuit boards materials are made by pressing materials in the 10∼30kgf/cm² under 160∼210°C for two hours, the physical measurement data such as listed in Table 5.

### Example 12

270 in the weight of epoxy resin A, 280 in the weight of epoxy resin D, 90 in the weight of NPPN-431 resin and 70 in the weight of NPPN-638 resin are evenly mixed and then doped with 126.1 in the weight of hardener of the inter-hydroquinone resin (RFN); and 0.4 in the weight of accelerator (2 - MZ) evenly mixed. It's treated with glass fiber cloth (7628) produced by in NAN YA PLASTICS CORPORATION. And semi-hardened into the film in 160 ∼ 180°C. It's stacked with five to eight film, from top to bottom by wrapped with copper foil I oz produced by NAN YA PLASTICS CORPORATION. Circuit boards materials are made by pressing materials in the 10∼30kgf/cm² under 160∼210°C for two hours, the physical measurement data such as listed in Table 5.

### Example 13

270 in the weight of epoxy resin A, 280 in the weight of epoxy resin D, 90 in the weight of NPPN-431 resin and 70 in the weight of NPPN-638 resin are evenly mixed and then doped with 191.3 in the weight of hardener of the melamine-phenolic resin (LA-1356, melamine type novolac, Japan's largest ink company); and 0.4 in the weight of accelerator (2 - MZ) evenly mixed. It's treated with glass fiber cloth (7628) produced by in NAN YA PLASTICS CORPORATION. And semi-hardened into the film in 160 ∼ 180°C. It's stacked with five to eight film, from top to bottom by wrapped with copper foil I oz produced by NAN YA PLASTICS CORPORATION. Circuit boards materials are made by pressing materials in the 10∼30kgf/cm² under 160∼210°C for two hours, the physical measurement data such as listed in Table 5.

### Comparative example 4

710 in the weight of epoxy resin E, and added 20.7 in the weight of dicyandiamide (DICY), are evenly mixed and then doped with 0.4 in the weight of accelerated (2 - MZ) evenly mixed. It's treated with glass fiber cloth (7628) produced by in NAN YA PLASTICS CORPORATION. And semi-hardened into the film in 160 ∼ 180°C. It's stacked with five to eight film, from top to bottom by wrapped with copper foil I oz produced by NAN YA PLASTICS CORPORATION. Circuit boards materials are made by pressing materials in the 10∼30kgf/cm2 under 160∼210°C for two hours, the physical measurement data such as listed in Table 5.

### Comparative Example 5

270 in the weight of epoxy resin A, 280 in the weight of epoxy resin D, 90 in the weight of NPPN-431 resin and 70 in the weight of NPPN-638 resin, 22.9 in the weight of dicyandiamide (DICY), are evenly mixed, and then doped with 0.4 in the weight of accelerator (2 - MZ) evenly mixed, and. It's treated with glass fiber cloth (7628) produced by in NAN YA PLASTICS CORPORATION. And semi-hardened into the film in 160 ∼ 180°C. It's stacked with five to eight film, from top to bottom by wrapped with copper foil I oz produced by NAN YA PLASTICS CORPORATION. Circuit boards materials are made by pressing materials in the 10∼30kgf/cm² under 160∼210 °C for two hours, the physical measurement data such as listed in Table 5.

**Table 5**

| constitute | example | | | | | | Comparative example | | |
|---|---|---|---|---|---|---|---|---|---|
| Materiel /weight | 7 | 8 | 9 | 10 | 11 | 12 | 13 | 4 | 5 |
| **Resin A** | | | | | | | | | |
| | 270 | 270 | 270 | 270 | 270 | 270 | 270 | | 270 |
| Resin D | 280 | 280 | 280 | 280 | 280 | 280 | 280 | | 280 |
| **Resin E** | | | | | | | | | |
| | | | | | | | | 710 | |
| NPPN-431 | 90 | 90 | 90 | 90 | 90 | 90 | 90 | | 90 |
| NPPN-638 | 70 | 70 | 70 | 70 | 70 | 70 | 70 | | 70 |
| NPEH-710H | 229.3 | | | | | | | | |
| NPEH-720H | | 275.1 | | | | | | | |
| BPN | | | 412.7 | | | | | | |
| SPN | | | | 206.3 | | | | | |
| TPN | | | | | 229. 3 | | | | |
| RFN | | | | | | 126.1 | | | |
| LA-1356 Dicyandiamide 2-MZ | 0.4 | 0.4 | 0.4 | 0.4 | 0.4 | 0.4 | 191.3 0.4 | 20.7 0.4 | 22.9 0.4 |
| Bromide content | 18.3 | 17.4 | 15.3 | 18.7 | 18.3 | 20.5 | 19.1 | 17.5 | 23.5 |

| Test data | | | | | | | | | |
|---|---|---|---|---|---|---|---|---|---|
| Item / data | 7 | 8 | 9 | 10 | 11 | 12 | 13 | 4 | 5 |
| Peeling strength (Ibf/inch) | 11.7 | 11.6 | 11.2 | 11.4 | 11.6 | 11.8 | 12.1 | 12.2 | 12.4 |
| Tg(°C) from DSC measurement | 162.2 | 168.3 | 158.6 | 171.1 | 168.8 | 175.4 | 170.5 | 169.8 | 173.8 |
| Pressure cooker 0.5hr | | | | | | | | | |
| Moisture absorption rate (wt%) | 0.17 | 0.17 | 0.18 | 0.18 | 0.18 | 0.18 | 0.17 | 0.29 | 0.28 |
| Heat resistance of soldering tin (sec) | >600 | >600 | >600 | >600 | >600 | > 600 | >600 | 170 | 190 |
| From TMA test to T-288 layer test (min) | 32.4 | 32.2 | 36.3 | 33.2 | 34.1 | 34.6 | 34.5 | 2.4 | 2.8 |
| 5% heat cracking temp (°C) from TGA measurement | 359 | 361 | 362 | 360 | 361 | 364 | 362 | 315 | 312 |
| Flame resistance UL-94 | V-0 | V-0 | V-0 | V-0 | V-0 | V-0 | V-0 | V-0 | V-0 |

| | | | | | | | | | |
|---|---|---|---|---|---|---|---|---|---|
| * physical testing is reference to IPC-TM-650 norms. * DSC: Differential Scanning Calorimeter * TMA: Thermomechanical analyzer * TGA: Thermogravimetry Analyzer | | | | | | | | | |

### PHYSICAL PROPERTY ANALYSIS:

Substrate with phenolic resin as a hardener, moisture absorption, heat-resistance and heat of cracking temperatures is much better than that of substrate with dicyandiamide as a hardener. Moisture absorption is less than 0.2%. These substrates are placed in solder tin furnace in 288°C 0.5 hour, after the test under pressure cooker is more than 600 seconds. These substrates aren't burst in the solder. The test of TMA at 288°C is more than 30 minutes without stratifying.

The glass transition temperature (Tg) of substrate is significantly impacted by the hardeners and NPPN-431 resin. Impact of the hardeners on Tg by inter-high to low is - hydroquinone resin (RFN)> salicylaldehyde resin (SPN)> Melamine-phenolic resin> glyoxal resin> MDA phenol resin> phenolic resin> benzaldehyde resin.

### EFFECTIVENESS OF INVENTION

From all the above examples, comparative examples, and physical properties, effectiveness of this invention are obtained as follows:
(1) The peeling strength between copper foil and substrate is mainly relation to brominated epoxy resin with oxazolidone ring. The higher proportion epoxy resin modified with oxazolidone ring in the total, the better adhesiveness with copper foil, and the greater peeling strength. The peeling strength of the present invention is more than 11 Ibf/inch, which is superior to the general copper foil substrate to use phenolic resin as hardener.
(2) The glass transition temperature (Tg) in the substrate of the present invention is higher than 155°C.The brominated resin with oxazolidone ring can improve Tg of the substrate, but mainly influenced by the hardener. However, m-hydroquinone resin (RFN), salicylaldehyde resin (SPN) and melamine-phenolic resin can increase its Tg more than 170 °C.
(3) While the substrate is to use phenolic resin as hardener, its moisture absorption is always low. After 0.5 hour pressure cooker test (120 °C, 2 atm), its moisture absorption is less than 0.2%. However, the dicyanamide is used as hardener of the substrate, its moisture absorption is more than 0.25%.
(4) The substrate is to use of phenolic resin composition as hardener, its heat resistance is also quite excellent. After 0.5 hour pressure cooker test at 288°C, and placed in the solder tin furnace is more than 600 seconds without burst plate. TMA at 288°C test is able to over 20 minutes without stratifying.
(5) Oxazolidone structure is able to enhance flame retardant. Therefore, the formula of the present invention is only to control the bromine content with 15 wt% above, it is able to pass UL-94 V-0.

Although the preferable embodiments of the present invention, are disclosed as above, the scopes of them are not restricted therein, any skilled one can modify and revise the practice of the present invention. All of these modifications and revisions still belong to the attached claims of the invention.

## Claims

1. A circuit board containing a resin composition, including:
(A) having about 5 ∼ 95wt% of epoxy resin modified with halide and oxazolidone ring. The epoxy resin is obtained from halide-containing epoxy resin mixed with the catalyst quaternary ammonium salt and then directly to react with isocyanate;
(B) having about 95 ∼ 5wt% of epoxy resin with two or more epoxy groups;
(C) hardeners, and
(D) accelerator.

2. The circuit broad resin composition as claimed in claim 1, wherein said (A) epoxy resin modified with halide contained in epoxy resin, wherein the halide-containing epoxy resin is brominated epoxy resin, epoxy equivalent is 200 ∼ 2000g/eq, MW = 500 ∼ 5000g/mol.

3. The circuit broad resin composition as claimed in claim 1, wherein said (B) epoxy resin containing two or more epoxy groups, is brominated epoxy resin, or halogen-free epoxy resins.

4. The circuit broad resin composition as claimed in claim 3, wherein the epoxy equivalent of brominated epoxy resin is 100 ∼ 1000g/eq, MW = 1000 ∼ 5000g/mol.

5. The circuit broad resin composition as claimed in claim 3, wherein said halogen-free epoxy resins is phenolic epoxy resin or multi-functional phenolic epoxy resin, the epoxy equivalent is 100 ∼ 1000g/eq.

6. The circuit broad resin composition as claimed in claim 1, wherein said (C), the ratio of hardener/epoxy resin in the amount is 0.5/1 to 1.5/1.

7. The circuit broad resin composition as claimed in claim 1, wherein said (C) hardener is able to be phenolic resin, bisphenol resin, glyoxal resin, benzaldehyde resin, salicylaldehyde resin, m-hydroquinone resins and melamine resin.

8. The circuit broad resin composition as claimed in claim 1, wherein said (D) accelerator is imidazole-type catalyst, the amount is 0.01 ∼ 0.5 phr of epoxy resin.

9. A manufacturing method for a circuit board, including the following steps:
(a) about 5 ∼ 95wt% of brominated epoxy resin and tetraethyl ammonium bromine catalysts with isocyanate to make reaction to form modified brominated epoxy resin containing oxazolidone;
(b) about 95 ∼ 5wt% of epoxy resin containing two or more epoxy groups and the halogen-free epoxy resin mixed uniform;
(c) doped with hardener and accelerator;
(d) treating with glass fiber cloth and baking in the temperature of 160 ∼ 180°C to produce prepreg; and
(e) to be pressed in the temperature of 170∼210°C and under the pressure of 10 ∼ 30kgf/cm² so as to form circuit boards.

10. The manufacturing method for a circuit board as claimed in Claim 9, wherein said glass fiber cloth after treating and semi-hardened into the film in 160 ∼ 180°C, stacked with five to eight film, from top to bottom by wrapped with copper foil, then made hot pressing, the preferable temperature being 180∼200°C and the preferable pressure being 15 ∼ 25kgf/cm².
